# EUROPEAN PATENT SPECIFICATION

(11) **EP 1 282 343 B1**
(45) Date of publication and mention of the grant of the patent: **10.06.2009**
(21) Application number: 00976308.7
(22) Date of filing: 16.11.2000
(51) Int. Cl.: H05K 3/46

(54) **METHOD OF PRODUCING MULTILAYER CIRCUIT BOARDS**
HERSTELLUNGSMETHODE FÜR EINE MEHRLAGIGE LEITERPLATTE
PROCEDE DE PRODUCTION DE CARTES DE CIRCUIT MULTICOUCHE

(30) Priority: 10.05.2000 JP 2000137144
(43) Date of publication of application: 05.02.2003
(73) Proprietor: IBIDEN CO., LTD., Ogaki-shi, Gifu 503-0917 (JP)
(72) Inventor: KARIYA, Takashi,, Ibi-gun, Gifu 501-0695 (JP)
(74) Representative: Müller-Boré & Partner Patentanwälte
(86) International application number: PCT/JP2000/008105
(87) International publication number: WO 2001/087024

(56) References cited:
- WO-A-98/56219
- JP-A- 4 010 696
- JP-A- 11 261 225
- US-A- 5 401 913
- PATENT ABSTRACTS OF JAPAN vol. 017, no. 629 (E-1462), 19 November 1993 (1993-11-19) -& JP 05 198946 A (FURUKAWA ELECTRIC CO LTD:THE), 6 August 1993 (1993-08-06)
- PATENT ABSTRACTS OF JAPAN vol. 1995, no. 02, 31 March 1995 (1995-03-31) -& JP 06 326438 A (NITTO DENKO CORP), 25 November 1994 (1994-11-25)

## Description

### TECHNICAL FIELD

The present invention relates to a method of manufacturing a multilayer circuit board.

### BACKGROUND ART

The build-up process is well known as a conventional method of manufacturing a multilayer circuit board. For example, a multilayer circuit board is manufactured as follows in this process. Firstly, via holes are formed at prescribed positions in a one-side copper-clad laminate manufactured by applying a copper foil to one side of an insulating substrate. The via holes are filled with an electrically conductive paste. A copper foil is bonded to the insulating substrate side of the one-side copper-clad laminate by pressing. The copper foil is etched so that a prescribed conductor circuit is formed.

A both-side printed board manufactured as described above serves as a core board. Insulating substrates are stacked on both sides of the core board respectively and bonded by pressing. Thereafter, via holes are formed at prescribed positions and then filled with a conductive paste. After copper foils are stacked on both sides of the board and pressed again, prescribed conductor circuits are formed on each copper foil. This step is repeated for further increase in the layers so that a multilayer circuit board is manufactured.

In the foregoing method, the both-side printed board serving as the core board is manufactured and circuit patterns are sequentially stacked on the core board. Accordingly, since the number of steps is increased, there is a definite limit in improvement of the manufacturing efficiency.

Furthermore, manufacture of the core board requires a step of bonding a copper foil by pressing in a conventional method. The pressing sometimes distorts the insulating substrate of the core board, whereupon positions of the via holes formed in the insulating substrate are sometimes displaced. Accordingly, a land needs to be rendered larger in consideration of allowance for displacement. This results in a problem that densification of the multilayer circuit board is difficult.

Additionally, when the insulating substrates are stacked on the core board, the pressing sometimes causes misregistration between the core substrate and each insulating board. Accordingly, an X-ray check hole needs to be previously formed so that the location of the inner conductor circuit is checked from the surface of the insulating board. This necessitates one extra step in the manufacture.

Doument JP 05 198 946 discloses the prior art portion of claim 1.

### DISCLOSURE OF THE INVENTION

The present invention is directed to a method of manufacturing a multilayer circuit board as defined in claim 1.

According to the invention, the printed boards each of which has one side formed with a conductor layer are stacked. An outermost conductor layer is stacked on the insulating layer side of the first outermost printed board disposed with the insulating layer side being directed outward. The printed boards are collectively pressed to be manufactured into a multilayer circuit board. Accordingly, the multilayer circuit board is manufactured by a single pressing operation. Consequently, the manufacturing steps can be simplified and the manufacturing efficiency can be improved.

Furthermore, since pressing is carried out just once, the possibility that the insulating substrate may be distorted and the possibility that the printed board may be shifted can be rendered minimum. Consequently, the precision of the multilayer circuit board can be improved.

According to the invention, the second outermost printed board is not previously etched and pressed under the condition where the thickness thereof is entirely uniform. Accordingly, since a uniform pressure is applied to the whole printed board in the pressing, the possibility of distortion and displacement can be rendered minimum. Consequently, the precision of the multilayer circuit board can be improved.

### BRIEF DESCRIPTION OF THE DRAWINGS

FIG. 1 is a sectional view (1) showing steps of manufacturing a multilayer circuit board of one embodiment in accordance with the present invention;
FIG. 2 is a sectional view (2) showing steps of manufacturing a multilayer circuit board of the embodiment in accordance with the present invention; and
FIG. 3 is a sectional view (3) showing steps of manufacturing a multilayer circuit board of the embodiment in accordance with the present invention.

### BEST MODE FOR ENFORCEMENT OF THE INVENTION

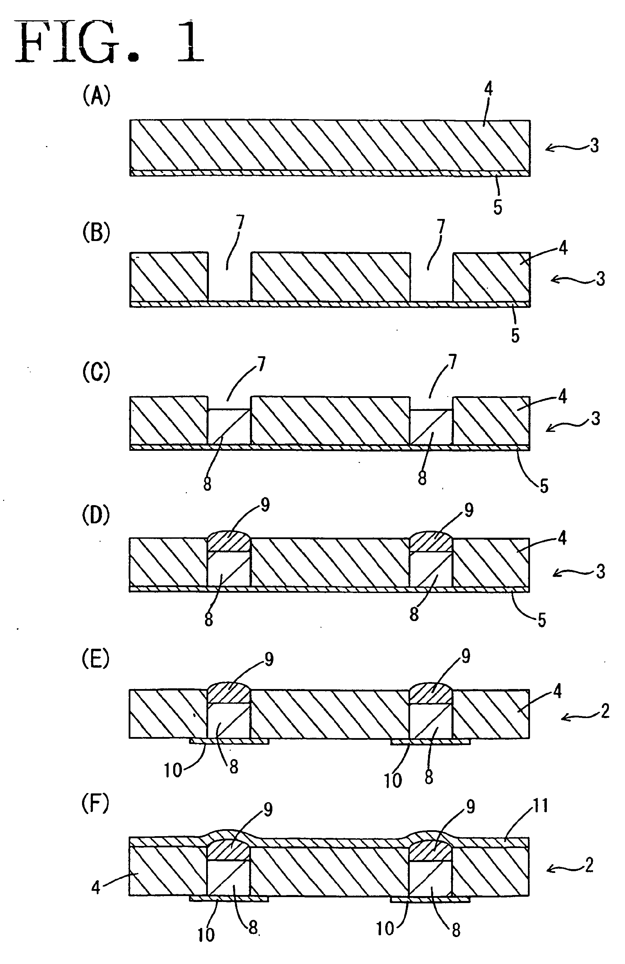

The present invention will be described with reference to FIGS. 1 to 3.

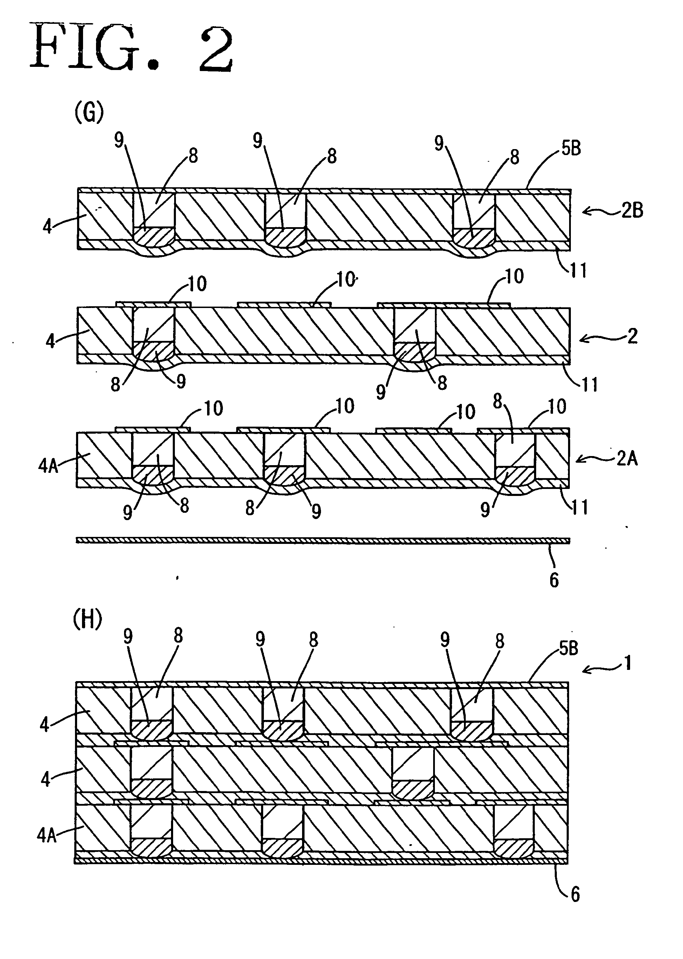

In the method of manufacturing the multilayer circuit board 1 in accordance with the present invention, a plurality of printed boards 2 are stacked and collectively pressed. The method is such that by stacking an outermost copper foil 6 (corresponding to an outermost conductor layer of the present invention) on a side of a first outermost printed board 2A at an insulating substrate 4A side and pressing, the printed board 2A having an insulating substrate 4 (corresponding to an insulating layer in the present invention) side being directed outward. See FIG. 2(G).

The method is further such that a copper foil 5B of a second outermost printed board 2B disposed with the copper foil 5B (corresponding to a conductor layer in the present invention) side being directed outward is not previously formed with a conductor circuit 10 and is pressed under a condition where the copper foil 5B remains on the whole side.

The manufacture of the printed board 2 forming the multilayer circuit board 1 starts with a one-side copper-clad laminate 3. The one-side copper-clad laminate 3 has a well known structure, that is, the copper foil 5 is affixed to overall one side of an insulating substrate 4 (the underside in FIG. 1) made of a plate-shaped glass-cloth epoxy resin (FIG. 1(A)).

Laser beams are irradiated onto prescribed locations on the insulating substrate 4 from the side of the substrate opposite the copper foil 5 (the upper side in FIG. 1) so that via holes 7 extending through the insulating substrate to the copper foil 5 are formed (FIG. 1(B)). The laser beam machining is executed by a pulse oscillation CO₂ gas laser, for example. In this case, the pulse energy preferably ranges between 2.0 and 10.0 mJ, the pulse width preferably ranges between 1 and 100 µs, the pulse interval is preferably at or above 0.5 ms, and the number of shots preferably ranges between 3 and 50.

Thereafter, desmearing is carried out in order that resin remaining in the via holes 7 may be removed. The desmearing includes a treatment of potassium permanganate, oxygen plasma discharge, corona discharge process, etc.

Subsequently, the copper foil 5 is covered with a protecting film made from polyethylene terephthalate although this state is not shown. In this state, a plated conductor 8 is formed in each via hole 7 by an electroplating with the copper foil 5 serving as one of electrodes (FIG. 1(C)). An amount of conductor 8 filling each via hole 7 is preferably determined so that an upper face thereof is slightly lower than the surface of the insulating substrate 4. Copper is most preferably as a plated metal but may be any metal which can be plated, such as tin, silver, solder, alloy of copper and tin, alloy of copper and silver, etc.

An electrically conductive bump 9 comprising a material with a low melting point, such as tin is formed by means of bump plating so that the bump overlaps the plated conductor 8 in each via hole 7. Each conductive bump 9 is formed so as to project slightly from the upper surface of the insulating substrate 4 (FIG. 1(D)). Subsequently, the copper foil 5 is etched so that a conductor circuit 10 is formed after the protecting film is stripped from the copper foil 5 (FIG. 1(E)).

A thermosetting adhesive (epoxy resin adhesive, for example) is applied by roll coating to the side of the printed board 2 on which the conductive bumps 9 are formed, whereby an adhesive layer 11 is formed (FIG. 1(F)).

A plurality of printed boards 2 manufactured as described above are aligned and overlapped (FIG. 2G). A second outermost printed board 2B of the top layer is overlapped without being etched. Accordingly, the copper foil 58 remains on the printed board 2B with a uniform thickness over the whole surface. The printed board 2B is disposed so that the copper foil 5B is directed outward (upward in FIG. 2) and the conductive bumps 9 are directed inward. The printed board 2 located below the printed board 2B is stacked so that the conductor circuits 10 are positioned at the upper side of the printed board 2. Thus, the printed boards are stacked so that the conductive bumps 9 of the printed board 2 located upward are connectable to the conductor circuits 10 of the lower printed board 2. Additionally, a first outermost printed board 2A located lowermost is stacked so that the insulating substrate 4A side formed with the adhesive layer 11 is directed outward (downward in FIG. 2). An outermost copper foil 6 is stacked on the surface of the printed board 2A.

The printed boards thus stacked are heated and pressed under vacuum at 180°C for 70 minutes so that the adhesive layer 11 is hardened, whereby the printed boards 2, 2A and 2B, and the outermost copper foil 6 are bonded together. The multilayer circuit board 1 in which the printed boards 2, 2A and 2B and outermost copper foil 6 are integrated is manufactured by one pressing operation (FIG. 2(H)). The distal ends of the conductive bumps 9 of each printed board are connected to prescribed locations of the conductor circuit 10 on the adjacent printed board 2, whereupon the conductor circuits 10 of the adjacent printed boards 2 are electrically connected to each other.

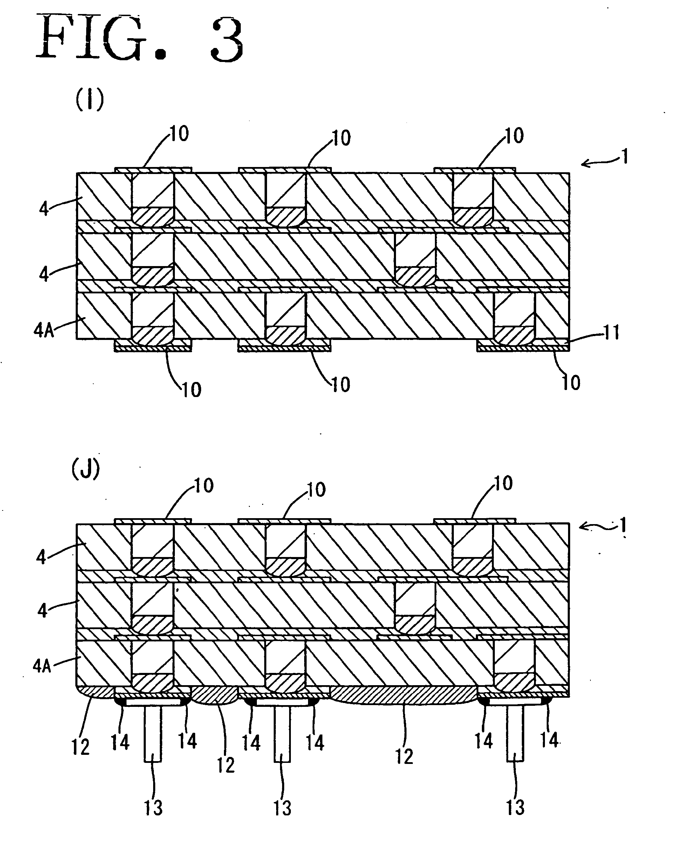

Subsequently, the copper foil 5B on the uppermost side and the outermost copper foil 6 affixed to the underside are etched so that conductor circuits 10 are formed (FIG. 3(I)).

A photosensitive solder resist 12 is applied to the whole underside and exposure and development processes are applied to the solder resist in a prescribed pattern so that the solder resist 12 is formed with openings which open lands formed at prescribed locations on the conductor circuit 10. Pins 13 for connecting the multilayer circuit board 1 to other components are bonded to the lands by solder 14. The multilayer circuit board 1 is thus manufactured.

According to the foregoing embodiment, the multilayer circuit board 1 is manufactured by stacking a plurality of printed boards 2 and stacking the outermost copper foil 6 on the insulating substrate 4A side of the first outermost printed board 2A disposed with the insulating substrate side being directed outward, and collectively pressing the stack. Accordingly, the multilayer circuit board 1 can be manufactured by a single time of pressing. Consequently, manufacturing steps can be simplified and the precision of the multilayer circuit board can be improved.

Furthermore, since pressing is carried out just once, the possibility that the insulating substrate 4 and the via holes 7 may be displaced can be rendered minimum. Consequently, the precision of the multilayer circuit board can be improved.

Furthermore, the copper foil 5B of the second outermost printed board 2B disposed with the copper foil side being directed outward is not previously etched, and the printed board 2B is pressed under the condition where the copper foil 5B having a uniform thickness all over is present. Accordingly, a uniform pressure can be applied to the whole printed board 2 and accordingly, the possibility that inner printed board 2 may be shifted or distorted can be rendered minimum. Consequently, the precision of the multilayer circuit board 1 can be improved.

The method of manufacturing the multilayer circuit board 1 can be applied to the manufacture of packages required of a particularly high precision. The underside on which the pins 13 are provided is preferably the outermost copper foil 6 side. The precision required for the lower layer side is lower than the precision required for the upper layer side and accordingly, the precision does not result in a problem even if the outermost copper foil 6 is stacked on the lowermost layer and pressed.

The technical scope of the present invention should not be limited by the above-described embodiment and covers equivalents thereof.

### INDUSTRIAL APPLICABILITY

The present invention can provided a method of manufacturing a multilayer circuit board which can simplify the manufacturing steps and improve the precision of the multilayer circuit board.

## Claims

1. A method of manufacturing a multilayer circuit board (1), in which a plurality of printed boards (2) is stacked and pressed into a multilayer circuit board (1), each printed board (2) having a conductor circuit (10) on one side of an insulating layer (4), the method comprising the steps of stacking the printed boards (2) with a bonding layer (11) interposed between the printed boards (2), stacking an outermost conductor layer (6) on an insulating layer side of a first outermost printed board (2A) with a further bonding layer interposed therebetween and pressing the stack so that the printed boards (2) and the outermost conductor layer (6) are bonded together, the first outermost printed board (2A) being disposed such that the insulating layer side is directed outwards from the stack, **characterized in that** a second outermost printed board (2B) having a copper foil (5B) of an entirely uniform thickness being directed outwards from the stack is disposed in the step of stacking the printed boards (2) on the side of the stack opposite to the first outermost printed board, and
wherein the copper foil (5B) and the outermost conductor layer (6) are etched after the step of pressing the stacked circuit boards (2), so that conductor circuits (10) are formed.

2. The method of manufacturing according to claim 1, **characterized in that** the printed boards (2) include via holes (7) extending through the insulating substrate (4) to the copper foil (5), a plated conductor (8) is formed in each via hole (7), and electrically conductive bumps (9) comprising a material with a low melting point are formed so as to overlap the plated conductor (8) and project from the upper surface of the insulating substrate (4); wherein when the plurality of printed boards (2) are pressed, the distal ends of the conductive bumps (9) of each printed board (2) are connected to prescribed locations of the conductor circuit (10) of the adjacent printing board (2), whereupon the conductor circuits (10) of the adjacent printed boards (2) are electrically connected to each other.

## Patentansprüche

1. Verfahren zur Herstellung einer mehrschichtigen Leiterplatte (1), in welchem eine Vielzahl von gedruckten Platten (2) gestapelt und zu einer mehrschichtigen Leiterplatte (1) gepresst wird, wobei jede gedruckte Platte (2) einen Leiterkreis (10) auf einer Seite einer Isolationsschicht (4) aufweist, wobei das Verfahren die Schritte
des Stapelns der gedruckten Platten (2) mit einer zwischen den gedruckten Platten (2) angeordneten Haftschicht (11),
des Stapelns einer äußersten Leiterschicht (6) auf eine Isolationsschichtseite einer ersten äußersten gedruckten Platte (2A), mit einer weiteren dazwischen angeordneten Haftschicht und
des Pressens des Stapels, so dass die gedruckten Platten (2) und die äußerste Leiterschicht (6) miteinander verbunden werden,
umfasst,
wobei die erste äußerste gedruckte Platte (2A) so angeordnet ist, dass die Isolationsschichtseite von dem Stapel nach Außen gerichtet ist, **dadurch gekennzeichnet, dass**
eine zweite äußerste gedruckte Platte (2B) mit einer Kupferfolie (5B) einer vollständig gleichförmigen Dicke, welche von dem Stapel nach Außen gerichtet ist, in dem Schritt des Stapelns der gedruckten Platten (2) auf der Seite des Stapels angeordnet ist, welche der ersten äußersten gedruckten Platte gegenüberliegt, und
wobei die Kupferfolie (5B) und die äußerste Leiterschicht (6) nach dem Schritt des Pressens der gestapelten Leiterplatten (2) geätzt werden, so dass Leiterkreise (10) gebildet werden.

2. Herstellungsverfahren nach Anspruch 1, **dadurch gekennzeichnet, dass** die gedruckten Platten (2) Kontaktlöcher (7) einschließen, welche sich durch das isolierende Substrat (4) zu der Kupferfolie (5) erstrecken,
wobei ein plattierter Leiter (8) in jedem Kontaktloch (7) gebildet wird und elektrisch leitfähige Höcker (9), welche ein Material mit einem niedrigen Schmelzpunkt umfassen, so gebildet werden, dass sie den plattierten Leiter (8) überlappen und von der oberen Oberfläche des isolierenden Substrats (4) hervorstehen,
wobei, wenn die Vielzahl von gedruckten Platten (2) gepresst wird, die distalen Enden der leitfähigen Höcker (9) jeder gedruckten Platte (2) mit vorgeschriebenen Stellen des Leiterkreises (10) der angrenzenden gedruckten Platte (2) verbunden werden, woraufhin die Leiterkreise (10) der angrenzenden Platten (2) elektrisch miteinander verbunden werden.

## Revendications

1. Procédé de fabrication d'une carte de circuit imprimé multicouche (1), dans lequel une pluralité de cartes de circuit imprimé (2) est empilée et pressée pour former une carte de circuit imprimé multicouche (1), chaque carte de circuit imprimé (2) ayant un circuit conducteur (10) sur une face d'une couche isolante (4), le procédé comprenant les étapes consistant à empiler les cartes de circuit imprimé (2) avec une couche de liaison (11) intercalée entre les cartes de circuit imprimé (2), empiler une couche conductrice extérieure (6) sur une face de couche isolante d'une première carte de circuit imprimé (2A) située le plus à l'extérieur avec une autre couche de liaison intercalée entre elles et presser la pile de sorte que les cartes de circuit imprimé (2) et la couche conductrice extérieure (6) soient liées l'une à l'autre, la première carte de circuit imprimé extérieure (2A) étant disposée de sorte que la face couche de isolante soit tournée vers l'extérieur de la pile ;
**caractérisé en ce qu'**une seconde carte de circuit imprimé (2B) située le plus à l'extérieur et ayant une feuille de cuivre (5B) d'une épaisseur tout à fait uniforme qui est tournée vers l'extérieur de la pile est disposée à l'étape d'empilage des cartes de circuit imprimé (2) sur la face de la pile opposée à la première carte de circuit imprimé située le plus à l'extérieur, et
dans lequel la feuille de cuivre (5B) et la couche conductrice extérieure (6) sont gravées après l'étape de pressage des cartes de circuit imprimé empilées (2) de sorte que des circuits conducteurs (10) soient formés.

2. Procédé de fabrication selon la revendication 1, **caractérisé en ce que** les cartes de circuit imprimé (2) comprennent des trous d'interconnexion (7) s'étendant à travers le substrat isolant (4) vers la feuille de cuivre (5), un conducteur revêtu (8) est formé dans chaque trou d'interconnexion (7), et des bosses conductrices de l'électricité (9) comprenant un matériau à faible point de fusion sont formées de manière à chevaucher le conducteur revêtu (8) et faire saillie de la surface supérieure du substrat isolant (4) ; dans lequel, lorsque le pluralité de cartes de circuit imprimé (2) est pressée, les extrémités distales des bosses conductrices (9) de chaque carte de circuit imprimé (2) sont connectées à des emplacements prescrits du circuit conducteur (10) de la carte de circuit imprimé adjacente (2), après quoi les circuits conducteurs (10) des cartes de circuit imprimé adjacentes (2) sont électriquement connectées l'un à l'autre.
